(19) Europäisches Patentamt
European Patent Office
Office européen des brevets

(11) **EP 4 400 912 A1**

(12) **EUROPEAN PATENT APPLICATION**

(43) Date of publication:
**17.07.2024 Bulletin 2024/29**

(21) Application number: **23150884.7**

(22) Date of filing: **10.01.2023**

(51) International Patent Classification (IPC):
**G03F 7/00** *(2006.01)*

(52) Cooperative Patent Classification (CPC):
**G03F 7/704**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **MYCRONIC AB**
**183 03 Täby (SE)**

(72) Inventors:
• **ISMAIL, Nur**
**171 45 Solna (SE)**
• **KARAWAJCZYK Andrzej**
**117 36 Stockholm (SE)**

(74) Representative: **AWA Sweden AB**
**Box 45086**
**104 30 Stockholm (SE)**

(54) **LASER WRITER AND METHOD FOR OPERATING A LASER WRITER**

(57) An irradiation arrangement (2) comprises an acousto-optical modulator (20), a multi-laser-beam source (10), a first lens array (50) of first beam lenses (52) and a writing head (40). The multi-laser-beam source provides parallel laser beams focused into the acousto-optical modulator. Focal points of the first beam lenses coincide with respective modulator channel positions (25) of the acousto-optical modulator or with respective modulator channel positions of an image plane of an imaging of the acousto-optical modulator. The writing head comprises an acousto-optical deflector (60), a collimator lens arrangement (62) and a second lens array (70) of second beam lenses (72). Focal points of the second beam lenses are positioned at the collimator object plane (64). The writing head is movable relative to the acousto-optical modulator along a light propagation path (X). A scanning lithographic laser writer and a method for operating a scanning lithographic laser writer are disclosed.

Fig. 3

EP 4 400 912 A1

## Description

TECHNICAL FIELD

The present technology relates in general to laser writers, and in particular to scanning lithographic laser writers having movable writing head, and methods for operating such laser writers.

BACKGROUND

Scanning lithographic laser writers, e.g. mask writers, use laser to generate or write highly detailed patterns. Pattern Generators (PG) can today generate features down to the size of 0.75 μm. Typically laser writers use a laser as the light source to activate a photoresist. In a typical example, the exposure laser works in the visible spectrum at 413.1 nm wavelength, i.e. violet. Power stability and low optical noise of the laser is crucial for writing performance.

Today, when the writing head moves, the movement of the writing head is compensated by moving a Diffractive Optical Element (DOE). Moving the DOE introduces a set of complications and has some disadvantages. Moving the DOE causes for instance a movement of the beams across multiple optical surfaces such as the AOM surfaces, the AOM lens surfaces and the collimation lens surfaces. If these surfaces over which the beams move are not perfect, the beams can pick up aberrations that can show as periodic imperfections in the printed pattern. Movement of the DOE must also be synchronized with the head movement in a very accurate way.

SUMMARY

A general object of the present technology is to improve the optical compensation for a moving writing head.

The above object is achieved by methods and devices according to the independent claims. Preferred embodiments are defined in dependent claims.

In general words, in a first aspect, an irradiation arrangement for a scanning lithographic laser writer comprises an acousto-optical modulator, a multi-laser-beam source, a first lens array and a writing head. The multi-laser-beam source is configured for providing parallel laser beams focused into respective modulator channel positions of the acousto-optical modulator. The first lens array comprises first beam lenses having parallel optical axes along a light propagation path. The first lens array is a one-dimensional array having a first pitch between the first beam lenses in a direction perpendicular to the light propagation path. Focal points of the first beam lenses are coinciding with the respective modulator channel positions of the acousto-optical modulator or with respective modulator channel positions of an image plane of an imaging of the acousto-optical modulator. Thereby parallel laser beams associated with a respective modulator channel position are provided. The writing head comprises a second lens array, a collimator lens arrangement, an acousto-optical deflector and a final lens arrangement. The collimator lens arrangement is configured to convert light from positions of a collimator object plane to respective beams of angles crossing each other at the acousto-optical deflector. The second lens array comprises second beam lenses having parallel optical axes along the light propagation path. The second lens array is a one-dimensional array having a second pitch between the second beam lenses in a direction perpendicular to the light propagation path. Focal points of the second beam lenses are positioned at the collimator object plane, whereby the parallel laser beams become focused at the collimator object plane. The writing head is movable relative to the acousto-optical modulator along the light propagation path.

In a second aspect, a scanning lithographic laser writer comprises an irradiation arrangement according to the first aspect, a substrate holder and a control unit. The substrate holder has attachment means for holding a substrate with a laser-light sensitive surface in a substrate plane. The control unit is configured for synchronize movements of the writing head relative to the substrate holder and the acousto-optical modulator to an operation of the acousto-optical modulator.

In a third aspect, a method for operating a scanning lithographic laser writer comprises moving a writing head of an irradiation arrangement relative to an acousto-optical modulator, a multi-laser-beam source, and a first lens array of first beam lenses of the irradiation arrangement and a substrate holder. The acousto-optical modulator is operated synchronized to the moving. The multi-laser-beam source is configured for providing parallel laser beams focused into respective modulator channel positions of the acousto-optical modulator. The first beam lenses have parallel optical axes along a light propagation path. The first lens array is a one-dimensional array having a first pitch between the first beam lenses in a direction perpendicular to the light propagation path. Focal points of the first beam lenses are coinciding with respective modulator channel positions of the acousto-optical modulator or with respective modulator channel positions of an image plane of an imaging of the acousto-optical modulator. The writing head comprises an acousto-optical deflector, a collimator lens arrangement configured to convert light from a number of positions of a collimator object plane to respective beams of a number of angles crossing each other at the acousto-optical deflector and a second lens array of second beam lenses. The second beam lenses have parallel optical axes along the light propagation path. The second lens array is a one-dimensional array having a second pitch between the second beam lenses in a direction perpendicular to the light propagation path. Focal points of the second beam lenses are positioned at the collimator object plane. The writing head is movable relative to the acousto-optical modulator along the light propagation path.

One advantage with the proposed technology is that it enables having a writer where all beams are fixed in position up to the deflector during an entire printing process. No moving parts are needed to be synchronized, which removes any need of complicated synchronization electronics. Since the beams pass through fixed positions , this will result in having the same quality of exposed spots throughout the entire plate. Other advantages will be appreciated when reading the detailed description.

BRIEF DESCRIPTION OF THE DRAWINGS

The invention, together with further objects and advantages thereof, may best be understood by making reference to the following description taken together with the accompanying drawings, in which:

FIG. 1 is a schematic drawing of an embodiment of a scanning lithographic laser writer;
FIGS. 2A-C are schematic illustrations of prior art beam paths for three different positions of the writing head;
FIG. 3 is a schematic illustration of an embodiment of an irradiation arrangement;
FIG. 4 is a schematic illustration of an embodiment of a multi-laser-beam source;
FIG. 5 is a schematic illustration of another embodiment of an irradiation arrangement;
FIG. 6 is a schematic illustration of a part of yet another embodiment of an irradiation arrangement;
FIG. 7 is a schematic illustration of a part of yet another embodiment of an irradiation arrangement;
FIG. 8 is a schematic illustration of yet another embodiment of an irradiation arrangement; and
FIG. 9 is a flow diagram of steps of an embodiment of a method for operating a scanning lithographic laser writer.

DETAILED DESCRIPTION

Throughout the drawings, the same reference numbers are used for similar or corresponding elements.

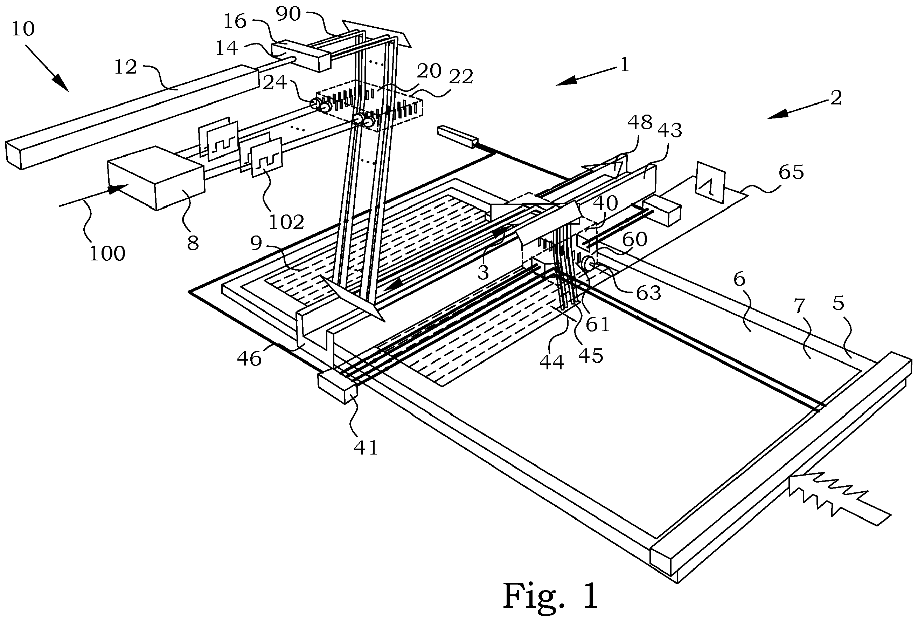

For a better understanding of the proposed technology, it may be useful to begin with a brief overview of a model system of a scanning lithographic laser writer 1, as illustrated by Figure 1. This embodiment of a scanning lithographic laser writer 1 is just an example of a system in which the present technology can be applied. The present technology may be used in any pattern generator using a multiple-channel acousto-optic modulator.

In an irradiation arrangement 2, a laser beam is generated by a laser source 12. A beam splitter 14 in the shape of a Diffractive Optical Element (DOE) 16 splits the laser beam into a number of separate beams 90. A set of mirrors and other optical elements direct the separate beams 90 to irradiate a light-sensitive target 7 of a substrate 6 at a substrate holder 5, to create a pattern 9 of exposures in the light-sensitive target 7. Each lens, mirror, optical crystal, etc. has some error, giving an energy spread. Print data 100 is provided to a control unit 8 for a multichannel acousto-optical modulator 20.

In the acousto-optical modulator 20, transducers 24 are used for creating acoustic waves through an acousto-optical crystal 22. Depending on the interaction between the acoustic waves and the separate laser beams 90 within the acousto-optical crystal 22, the separate laser beams 90 can be switched on and off in registry with the moving of the separate laser beams 90 over the light-sensitive target 7, thereby giving rise to the requested pattern.

The control unit 8 provides modulated radio-frequency signals 102 based on the print data to respective transducers 24 of the multichannel acousto-optical modulator 20 via electrical input connectors.

The separate laser beams 90 are moved over the light-sensitive target by several mechanisms. A Y-interferometer 41 utilizes laser beams from a laser source to determine the position of the separate laser beams 90 in a Y direction. An X-interferometer 42 is analogously determining the position in an X direction. Mirrors at a movable writing head 40 are used for this purpose.

The writing head 40 in an X-carriage is movable along an X-bridge 43 in the direction of the light propagation path 3, as indicated by the arrow 48, and the substrate holder 5 is movable stepwise in the Y-direction relative to the X-bridge 43 as indicate by an arrow. The X-carriage thus scans in the X direction (scan strips). During the X-carriage return stroke, the Y-stage carrying the substrate holder 5 moves one step length (scan strip width). A microsweeping is also available in the Y direction by sweeping the separate laser beams 90 as indicated by the arrow 44, thereby moving the irradiation spots 45 of the separate laser beams 90. The microsweeping is in this embodiment achieved by an acousto-optic deflector 60, having an acousto-optical crystal 61. A transducer 63 is provided with a sweep signal 65, that is coordinated with the other motions and with the print data 100. The exposure is thus made by writing several microsweeps in one scan strip. The AOD deflector crystal 61 generates a sweep for all separate beams 90 together and controls power and linearity over the sweep.

The printed pattern 9 on the light-sensitive target 7 thus depends on that the separate laser beams 90 are given the right modulation in agreement with the microsweeping and other movement action of the printing head. The AOM modulator crystal 22 controls the power for each separate beam 90 and converts pattern data 100 to exposure light.

The present technology is focused on the light path between the multi-laser-beam source 10 and the writing head 40.

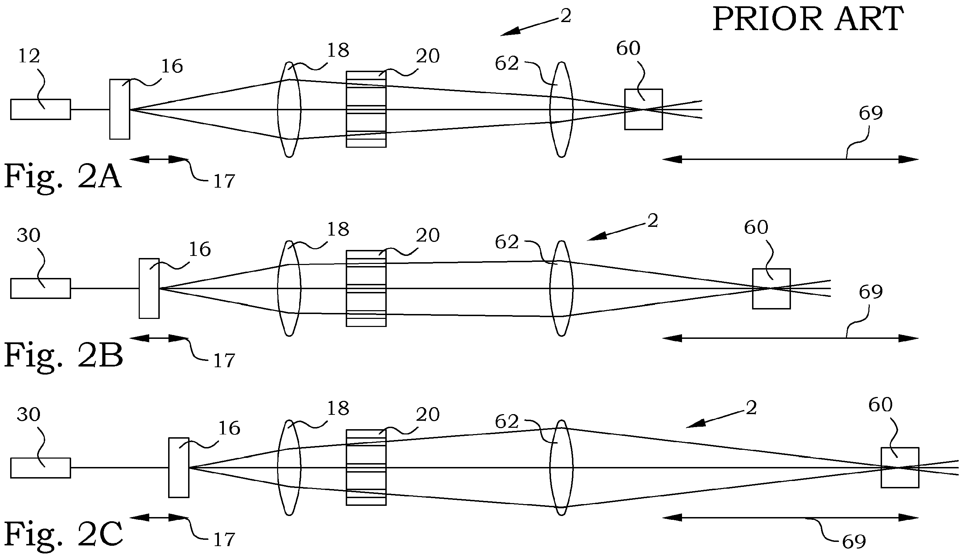

In earlier scanning lithographic laser writer machine configurations, a movement of the DOE has typically to be performed in synchronization with the motion of the optical head. In scanning lithographic laser writer machines intended for the display industry, where the optical head moves along the x-bridge while writing the pattern, there has up to now typically been a need to perform a x-carriage motion compensation. This can be understood from the Figures 2A-C.

The figures show three moments during a prior art writing process in which an optical head, of which only the AOD 60 is illustrated, is located at three different positions along the x-bridge. In each position in which the optical head is located it is required that all the beams generated by the DOE 16 should enter the AOD 60 under the exact same angles and to cross at its input. The number of beams is up to 15 in some machines today, and could reach even larger number in future machines. In this way the final lens would receive a constant input and perform in the exact same way as the head moves along the x-bridge. A movement, illustrated by the arrow 69, of the AOD 60 thereby requires that the DOE 16 is moved accordingly, as is illustrated by the arrow 17.

If only the optical head was moved between the position of Figure 2A to the position of Figure 2B or Figure 2C without adjusting the position of the DOE 16, that is the originating source of the beams, then the beams would still cross in the same location as in Figure 2A, while the AOD 60 would be in the new location as shown in Figure 2B or Figure 2C. This obviously will not work. In order to bring the crossing point of the beams forward to the new location of the AOD 60, the source of the beams, i.e. the DOE 16, has to be moved forward as well, as shown in Figure 2B or Figure 2C. The distance by which the DOE 16 has to be moved forward is proportional to the distance the optical head has moved. The exact proportionality constant depends on the angular magnification of the optical system between DOE 16 and head-optics.

A simple way of understanding the previous figure is to think of each lens as an optical element that converts angle to position, the pre-modulator lens arrangement 18 (AOM lenses), or position to angle, the collimator lens arrangement 62. For example, the beams originating at the DOE 16 all come from the same position in space but under different angles. These angles are converted to separate positions in space inside the AOM 20 by the pre-modulator lens arrangement 18. At the output of the AOM 20 there are separate light sources. These separate positions are then converted by the collimator lens arrangement 62 into separate angles which cause the beams to cross at the AOD 69.

As can be seen from these Figures, the movement of the DOE 16 causes the beams to move across the surfaces of all the optical elements between the DOE 16 and the optical head. This movement caused each beam to pick up imperfections of the lens surfaces that lead to varying aberrations in the beam shape that change periodically as the head moves up and down along the x-bridge. A fixed optical system would therefore be beneficial.

As can be seen in Figures 2A-C, the distance between adjacent beams only depends on the angle between adject beams introduced by the DOE, which is constant, and not on the distance of the DOE from the pre-modulator lens arrangement 18, also referred to as an AOM lens. In this way, changing the distance of the DOE 16 from the pre-modulator lens arrangement 18 will not change the positions of the focal spots inside the AOM 20 but only the propagation directions of the beams. There will therefore be a particular distance of the DOE 16 from the pre-modulator lens arrangement 18, close to the situation of Figure 2B, for which the beams exiting the pre-modulator lens arrangement 18 will propagate parallel to each other. This distance is exactly equal to the effective focal length (EFL) of the pre-modulator lens arrangement 18. This will be discussed further below.

Since each beam is focused inside the AOM 20, then at the output of the AOM 20 it will strongly diverge. Since the AOD 60 requires collimated beams at its input, a collimator lens arrangement 62 comprising a set of collimation lenses to collimate the beams before entering into the AOD, is provided. These lenses guarantee that the beams cross at the AOD location.

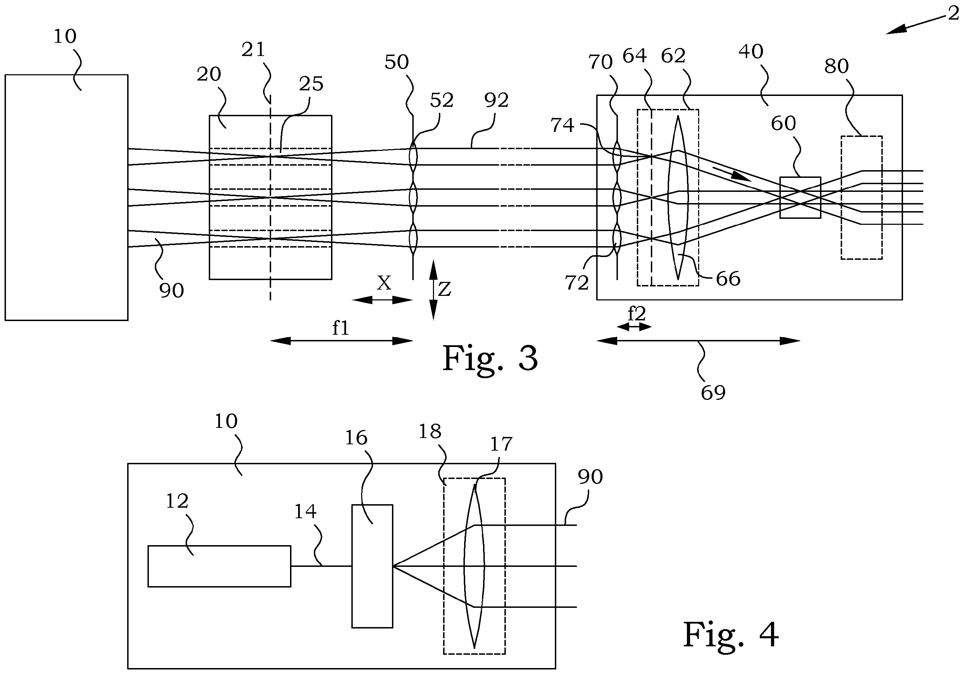

A discussion about how the lens-array solution can be used to avoid x-carriage motion compensation will be made in connection with Figure 3, in which an embodiment of an irradiation arrangement 2 for a scanning lithographic laser writer is illustrated schematically. The illustration is made with 3 beams.

However, the principles discussed herein are valid for any number of beams. Today a single laser beam may typically be split into 15 beams. A multi-laser-beam source 10 is configured for providing parallel laser beams 90 focused into respective modulator channel positions 25 of an acousto-optical modulator (AOM) 20.

In one embodiment, described more in detail below, the parallel laser beams are provided using a DOE. The laser beam incident onto the DOE is collimated, and the number of beams at the output of the DOE are therefore also collimated, but propagate in different directions with an equal angle between adjacent beams. The angle depends on the design of the DOE. AOM lenses focus these beams in the center of the AOM crystal into focal spots that coincide exactly with the locations of the acoustic waves, i.e. into the respective modulator channel positions 25 of the AOM 20. This means that the distance between adjacent beams is equal to the distance between the modulator channel positions 25.

With reference to Figure 3, the lens arrangements can be used differently compared to prior art. Assume e.g. that the distance between the DOE and the pre-modulator lens arrangement is fixed to the EFL. In this case the multitude of beams 90 propagate parallel to each other but strongly diverge at the output of the AOM 20. In more general words, a multi-laser-beam source 10 is configured for providing parallel laser beams 90 focused into respective modulator channel positions 25 of an AOM 20.

In this embodiment, a first lens array 50 of first beam lenses 52. The first beam lenses 52 are equal with focal length f1 and pitch exactly matching the pitch of the modulator channel positions 25 at the focal distance from the center of the AOM 20. In other words, the first beam lenses 52 have parallel optical axes along a light propagation path X. The first lens array 50 is a one-dimensional array having a first pitch between the first beam lenses 52 in a direction Z perpendicular to the light propagation path X. The focal points in a focal plane 21 of the first beam lenses 52 are coinciding with respective modulator channel 25 positions of the AOM. Parallel laser beams 92 associated with a respective modulator channel 25 position are provided. In this way all beams 92 will be collimated after the first lens array 50 and will still propagate parallel to each other.

A movable writing head 40 comprises a collimator lens arrangement 62, an acousto-optical deflector 60 and a final lens arrangement 80. The collimator lens arrangement 62 is configured to convert light from positions of a collimator object plane 64 to respective beams of angles crossing each other at the acousto-optical deflector 60. The microsweeping is achieved by the acousto-optic deflector 60. The final lens arrangement 80, typically comprising a cylindrical lens, provides an array of parallel beams from of the micro-swept beams exiting from the acousto-optic deflector 60. This array of parallel beams therefore becomes micro-swept in the Y direction on the target, according to procedures, known as such in prior art.

In an ideal situation, these beams 92 will reach the movable writing head 40 without changing significantly in size. However in reality, since they are gaussian beams they will slightly diverge. If it is assumed that, despite this divergence, the beam diameter will not exceed the pitch between the first beam lenses 52, as well as the clear aperture of the lenses, even when the optical head 40 is in its furthest position, then it is possible to place another, second lens array 70 on the writing head 40, together with the collimator lens arrangement 62.

The second lens array 70 has the purpose to focus the beams 92 into separated spots. To this end, the second lens array 70 comprises second beam lenses 72. The second beam lenses 72 have parallel optical axes along the light propagation path X. The second lens array 70 is a one-dimensional array having a second pitch between the second beam lenses in a direction Z perpendicular to the light propagation path X. Focal points 74 of the second beam lenses 72 are positioned at the collimator object plane 64, whereby the parallel laser beams become focused at the collimator object plane 64. The light spots at the collimator object plane 64 are thus separated by the second pitch. These spots act as separate light sources exactly as we had before at the exit of the AOM 20, but this time on the writing head 40. The beam lenses 72 has typically a much smaller radius of curvature than first beam lenses 52 and is, as explained, used to emulate the AOM output.

The collimator lens arrangement 62 has the same purpose as in the current systems, i.e. to collimate the beams and to have them cross at the AOD 60 location. As was discussed before, the collimator lens arrangement 62 basically converts position into angle. The focal length f2 controls how fast the beams will diverge, and is preferably chosen so that in combination with the collimator lens arrangement 62, the beam size at the AOD 60 is within a specified range for the AOD 60.

The writing head 40 is thereby movable relative to the AOM 20 in the first direction X over a distance 69. This movement can thus be provided without requiring any synchronized movements of parts of the multi-laser-beam source 10, the AOM 20 or the first lens array 50.

Another purpose of the collimator lens arrangement 62 is alpha-scaling, which actually means to achieve tunability of the crossing angle at the AOD 60. This in turn results in tunability of the beam separation on plate to be irradiated. This additional feature is achieved already today and may be utilized also with this new lens arrangement proposal. The collimation lens is sketched as a single lens but can be made out of two or more lenses. This will make it tuneable so that the focal length can be adjusted, and therefore also the angle between the different beams, to perform the alpha-scaling in the machine. In other words, alpha-scaling is typically based on two collimator lenses on motorized rails in order to adjust their position and combined focal length to achieve the wanted angular spacing.

Figure 4 illustrates one preferred embodiment of a multi-laser-beam source 10. However, it should be emphasized that also other types of multi-laser-beam sources 10 configured for providing parallel, preferably Gaussian, laser beams focused into respective modulator channel positions of an acousto-optical modulator are useful together with the technology presented herein.

In the embodiment of Figure 4, the multi-laser-beam source 10 comprises a laser source 12, a beam splitter 16 and a pre-modulator lens arrangement 18. The pre-modulator lens arrangement 18 is configured to direct split beams from the beam splitter 16 as the parallel laser beams 90 towards the AOM. The pre-modulator lens arrangement 18 is further configured to focus the directed split beams into the respective modulator channel positions of the AOM.

If the beams are collimated before the pre-modulator lens arrangement 18, then they will be focused into the AOM channels if the distance between the back-principal-plane of the pre-modulator lens arrangement 18 and the AOM channels coincides with the back-effective focal length (EFL) of the pre-modulator lens arrangement 18. Furthermore, the angles at which the beams are propagating should be related to the AOM channel spacing and to the EFL of the pre-modulator lens as:

$$\theta = \arctan(\mathrm{spacing}/\mathrm{EFL}).$$

The incoming beams should have well defined angles of propagation to end up in the AOM channel locations!

Furthermore, the beams 90 exiting the multi-laser-beam source 10 should propagate parallel to each other, while at the same time being focused into the AOM. This is possible if the distance between the beam-splitter 16 and the first principal plane of the pre-modulator lens arrangement 18 is equal to the front-EFL. Given that, the beam splitter 16 splits the beams with the perfect angular relation required to end up in the AOM channels starting from a single source beam. This is preferably done by a DOE.

In a typical embodiment, the first lens array 50 may e.g. have 15 first beam lenses 52 with a pitch of 900 μm and a lens clear aperture of 700 to 800 μm. In such an embodiment, the pitch is suitable to be matched to typical AOM channel separations, and the first lens array 50 may therefore image the AOM directly.

In other words, in one embodiment, the focal points of the first beam lenses 52 are coinciding with respective modulator channel positions of the acousto-optical modulator. The first pitch thus becomes equal to a distance between adjacent the modulator channel positions.

In the embodiment discussed above in connection with Figure 3, the pitch between the AOM channels 25 is 900um. Therefore, the beam diameters exiting from the first lens array 50 must be smaller than 900um. Such gaussian beams 92 will, however, diverge very rapidly since a gaussian beam divergence is inversely proportional to its waist size. For long distance movements 69 of the writing head 40, which may be even a meter or two, this may be a limiting factor.

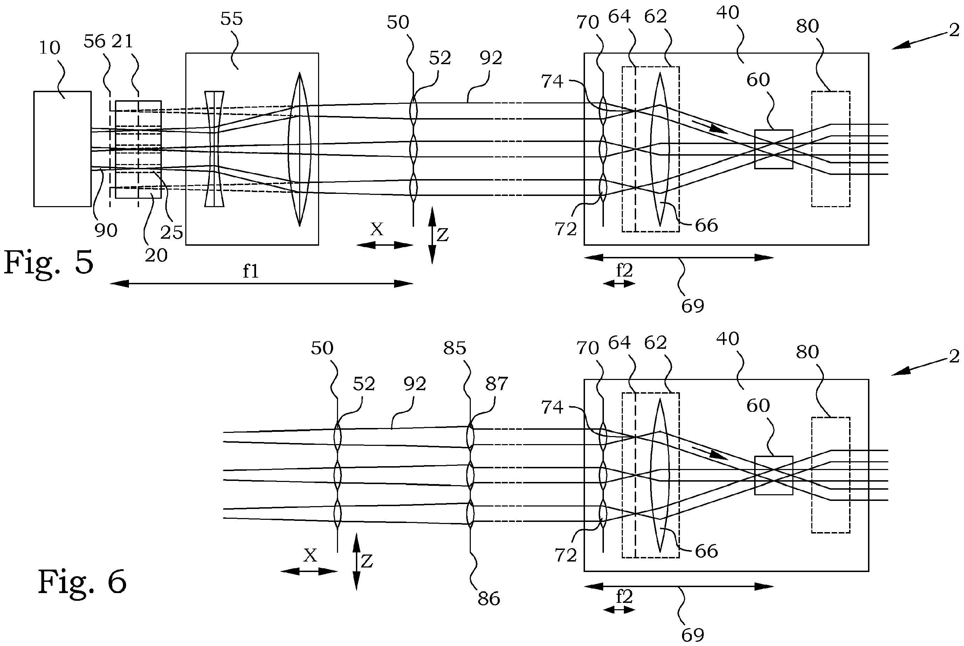

For such applications, in order to slow down the divergence one may instead increase the beam diameter of the beam leaving the first lens array. For this purpose, in another embodiment as illustrated in Figure 5, a telescope arrangement 55 may be used between the AOM 20 and the first lens array 50. The telescope arrangement 55 has the purpose of magnifying the AOM pitch and to allow the use of larger first beam lenses 52 in the first lens array 50. The use of larger beam lenses 52 will allow longer propagation distances 69 for the writing head 40 without having the gaussian beams 92 to exceed the size of the second beam lenses 72. This thereby makes the long-stroke systems more robust.

In such an embodiment, the focal length f1 is such that the focal points of the first beam lenses 52 are coinciding with respective modulator channel positions of an image plane 56 of an imaging of the AOM 20.

In other words, in one embodiment, the irradiation arrangement 2 comprises a telescope arrangement 55 positioned between the AOM 20 and the first lens array 50. The telescope arrangement 55 has an object plane at the modulator channel positions 25 of the AOM 20. The focal points of the first beam lenses 52 are coinciding with respective modulator channel positions of an image plane 56 of an imaging of the AOM 20.

In Figure 5, the telescope arrangement 55 is illustrated as consisting of two lenses, one concave and one convex. However, this illustration is only schematic and any type of telescope arrangement 55 may be used that is configured to enlarge the pitch of a set of parallel beams, and may also include a turn upside-down of the set of parallel beams.

In an alternative or complementary embodiment, as illustrated schematically in Figure 6, additional optical components are used between the first lens array 50 and the second lens array 70. As mentioned above, due to beam divergence, which depends on the waist-size of the gaussian beams 92 collimated by the first lens array 50, an additional adjustment of the beam size can be provided before reaching the writing head 40. In one embodiment, the irradiation arrangement 2 therefore an intermediate lens arrangement 85 positioned between the first lens array 50 and the second lens array 70. The intermediate lens arrangement 85 is configured to re-collimate the beams.

In this particular embodiment, the intermediate lens arrangement 85 comprises a third lens array 86 of third beam lenses 87 aligned with respective third beam lenses 52 of the second lens array 50 along the light propagation path X. The third lens array 86 with the third beam lenses, equal to the number of beams, is thereby used for re-collimating the beams. Preferably, the third lens array 86 is provided stationary with respect to the second lens array 50 or with respect to the writing head 40.

For large required movements of the writing head 40, or if the distance between the AOM 20 and the writing head 40 is very large, additional or alternative intermediate lens arrangements may have to be provided.

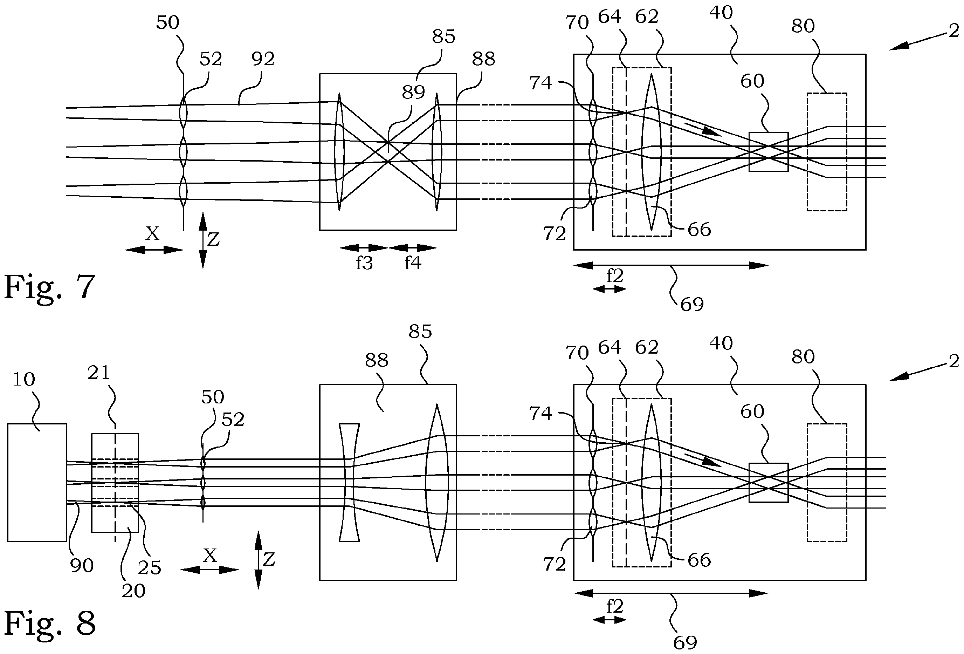

In another embodiment, as schematically illustrated in Figure 7, the intermediate lens arrangement 85 comprises a collimation set of lenses in a telescope configuration in a telescope module 88, covering all beams 92. The telescope module 88 comprises a pair of lenses with sufficiently large aperture to include all beams 92 in a telescope configuration. Thus, a first lens and second lens are together used to re-collimate the beams. The first lens has focal length f3 and will be placed at a distance f3 from the beam crossing 89 and is thus used to have the beams 92 crossed at a distance f3 from the lens. At the same time, the first lens focuses them, creating crossing beam waists at approximately the distance f3. The beams 92 are not perfectly collimated and the location of the beam waist may therefore be a bit further out than the crossing point 89. A second lens with focal length f4 will be placed at distance about f3+f4 from the first lens and is used to re-create the set of parallel quasi-collimated beams. If needed more than one module can be introduced, depending on the distance to be covered and the waist-size of the beams. f3 and f4 can be identical, as is illustrated, if no magnification is required. In this embodiment, the beams will also change their relative positions, upside down as illustrated. Without magnification, the pitches of the first and second lens arrays 20, 50 are equal and aligned.

In other words, in one embodiment, the second pitch is equal to the first pitch and in that the second beam lenses are aligned to the first beam lenses along the light propagation path.

Other types of telescope modules 88 can also be used, e.g. as is illustrated in Figure 8. Here, the telescope module 88 does not only re-collimate the beams, but it also magnifies the beam array. As discussed earlier, use of larger beams may reduce the beam divergence. In other words, in one embodiment, the intermediate lens arrangement 85 has a magnification different from unity.

All of the above presented irradiation arrangements are applicable to scanning lithographic laser writers, such as e.g. illustrated in Figure 1. As can be seen, the light propagation path in such scanning lithographic laser writers 1 is typically not straight, but controlled by different kinds of mirror arrangements. In the illustrations above, such mirror arrangements have been neglected and the light propagation path has been illustrated as straight, for improving the readability and make it easier to understand the optical properties correctly. However, any person skilled in the art realizes that the same principles are applicable to non-straight light propagation paths as well.

In a preferred embodiment, the scanning lithographic laser writer 1 comprises an irradiation arrangement 2 according to the principles presented here above. The scanning lithographic laser writer 1 further comprises a substrate holder 5 having attachment means for holding a substrate 6 with a laser-light sensitive surface 7 in a substrate plane. The scanning lithographic laser writer 1 further comprises a control unit 8. The control unit 8 is configured for synchronize movements of the writing head 40 relative to the substrate holder 5 and the AOM 20 to an operation of the AOM 20.

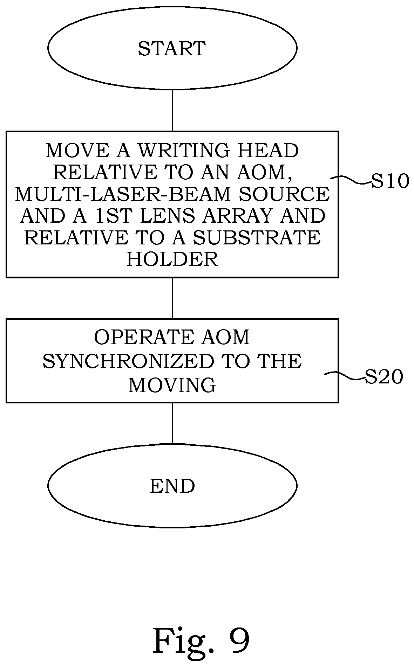

Figure 9 illustrates a flow diagram of steps of an embodiment of a method for operating a scanning lithographic laser writer. In step S10, a writing head of an irradiation arrangement is moved relative to an AOM, a multi-laser-beam source, and a first lens array of first beam lenses of the irradiation arrangement and a substrate holder. In step S20, the AOM is operated synchronized to the moving. The multi-laser-beam source is configured for providing parallel laser beams focused into respective modulator channel positions of the AOM. The first beam lenses have parallel optical axes along a light propagation path. The first lens array is a one-dimensional array having a first pitch between the first beam lenses in a direction perpendicular to the light propagation path. Focal points of the first beam lenses are coinciding with respective modulator channel positions of the AOM or with respective modulator channel positions of an image plane of an imaging of the AOM. The writing head comprises an AOD, a collimator lens arrangement configured to convert light from a number of positions of a collimator object plane to respective beams of a number of angles crossing each other at the AOD and a second lens array of second beam lenses. The second beam lenses have parallel optical axes along the light propagation path. The second lens array is a one-dimensional array having a second pitch between the second beam lenses in a direction perpendicular to the light propagation path. Focal points of the second beam lenses are positioned at the collimator object plane. The writing head being movable relative to the AOM along the light propagation path.

This technology provides a way to have a static beam path, i.e., with no moving parts between the laser output and the writing head, while the writing head is moved along the x-bridge.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. An irradiation arrangement (2) for a scanning lithographic laser writer (1), comprising:

   - an acousto-optical modulator (20);
   - a multi-laser-beam source (10), configured for providing parallel laser beams (90) focused into respective modulator channel positions (25) of said acousto-optical modulator (20);
   - a first lens array (50) of first beam lenses (52);

      wherein said first beam lenses (52) having parallel optical axes along a light propagation path (X);
      wherein said first lens array (50) being a one-dimensional array having a first pitch between said first beam lenses (52) in a direction (Z) perpendicular to said light propagation path (X);
      wherein focal points of said first beam lenses (52) are coinciding with respective modulator channel positions (25) of said acousto-optical modulator (20) or with respective modulator channel positions (25) of an image plane (56) of an imaging of said acousto-optical modulator (20);
      whereby parallel laser beams (92) associated with a respective modulator channel position (25) are provided;

- a writing head (40), comprising;

- an acousto-optical deflector (60);
- a collimator lens arrangement (62) configured to convert light from positions of a collimator object plane (64) to respective beams of angles crossing each other at said acousto-optical deflector (60);
- a final lens arrangement (80); and
- a second lens array (70) of second beam lenses (72);

wherein said second beam lenses (72) having parallel optical axes along said light propagation path (X);

wherein said second lens array (70) being a one-dimensional array having a second pitch between said second beam lenses (72) in a direction (Z) perpendicular to said light propagation path (X);

wherein focal points of said second beam lenses (72) are positioned at said collimator object plane (64), whereby said parallel laser beams (92) become focused at said collimator object plane (64); and

wherein said writing head (40) being movable relative to said acousto-optical modulator (20) along the light propagation path (X).

2. The irradiation arrangement according to claim 1, **characterized in that** said focal points of said first beam lenses (52) are coinciding with respective modulator channel positions (25) of said acousto-optical modulator (20), whereby said first pitch becomes equal to a distance between adjacent said modulator channel positions (25).

3. The irradiation arrangement according to claim 1, **characterized by**

- a telescope arrangement (55) positioned between said acousto-optical modulator (20) and said first lens array (50);

said telescope arrangement (55) having an object plane at said modulator channel positions (25) of said acousto-optical modulator (20);

wherein said focal points of said first beam lenses (52) are coinciding with respective modulator channel positions of an image plane (56) of an imaging of said acousto-optical modulator (20).

4. The irradiation arrangement according to any of the claims 1 to 3, **characterized by**

- an intermediate lens arrangement (85) positioned between said first lens array (50) and said second lens array (70);

said intermediate lens arrangement (85) being configured to re-collimate said beams (92).

5. The irradiation arrangement according to claim 4, **characterized in that** said intermediate lens arrangement (85) comprises a third lens array (86) of third beam lenses (87) aligned with respective beam lenses (72) of said second lens array (70) along said light propagation path (X).

6. The irradiation arrangement according to claim 4 or 5, **characterized in that** said intermediate lens arrangement (85) comprises a collimation set of lenses in a telescope configuration (88) covering all beams (92).

7. The irradiation arrangement according to any of the claims 1 to 6, **characterized in that** said second pitch is equal to said first pitch and **in that** said second beam lenses (72) are aligned to said first beam lenses (52) along said light propagation path (X).

8. The irradiation arrangement according to any of the claims 4 to 6, **characterized in that** said intermediate lens arrangement (85) has a magnification different from unity.

9. The irradiation arrangement according to any of the claims 1 to 8, **characterized in that** said multi-laser-beam source (10) comprises:

- a laser source (12);
- a beam splitter (16); and
- a pre-modulator lens arrangement (18) configured to direct split beams from said beam splitter (16) as said parallel laser beams (90) towards said acousto-optical modulator (20) and to focus said directed split beams (90) into said respective modulator channel positions (25) of said acousto-optical modulator (20).

10. A scanning lithographic laser writer (1), comprising:

- an irradiation arrangement (2) according to any of the claims 1 to 8;
- a substrate holder (5) having attachment means for holding a substrate (6) with a laser-light sensitive surface (7) in a substrate plane; and
- a control unit (8);

wherein said control unit (8) is configured for synchronize movements of said writing head (40) relative to said substrate holder (5) and said acousto-optical modulator (20) to an operation of said acousto-optical modulator (20).

**11.** A method for operating a scanning lithographic laser writer (1), comprising the steps of:

- moving (S10) a writing head (40) of an irradiation arrangement (2) relative to an acousto-optical modulator (20), a multi-laser-beam source (10), and a first lens array (50) of first beam lenses (52) of said irradiation arrangement (2) and a substrate holder (5); and
- operating (S20) said acousto-optical modulator (20) synchronized to said moving;

wherein said multi-laser-beam source (10) being configured for providing parallel laser beams (90) focused into respective modulator channel positions (25) of said acousto-optical modulator (20);

wherein said first beam lenses (52) having parallel optical axes along a light propagation path (X);

wherein said first lens array (50) being a one-dimensional array having a first pitch between said first beam lenses (52) in a direction (Z) perpendicular to said light propagation path (X);

wherein focal points of said first beam lenses (52) are coinciding with respective modulator channel positions (25) of said acousto-optical modulator (20) or with respective modulator channel positions of an image plane (56) of an imaging of said acousto-optical modulator (20);

wherein said writing head (40) comprises an acousto-optical deflector (60), a collimator lens arrangement (62) configured to convert light from a number of positions of a collimator object plane (64) to respective beams of a number of angles crossing each other at said acousto-optical deflector (60) and a second lens array (70) of second beam lenses (72);

wherein said second beam lenses (72) having parallel optical axes along said light propagation path (X);

wherein said second lens array (70) being a one-dimensional array having a second pitch between said second beam lenses (72) in a direction (Z) perpendicular to said light propagation path (X);

wherein focal points of said second beam lenses (72) are positioned at said collimator object plane (64); and

wherein said writing head (40) being movable relative to said acousto-optical modulator (20) along said light propagation path (X).

Fig. 1

Fig. 2A

Fig. 2B

Fig. 2C

PRIOR ART

EP 4 400 912 A1

Fig. 3

Fig. 4

EP 4 400 912 A1

Fig. 5

Fig. 6

Fig. 7

Fig. 8

EP 4 400 912 A1

START

MOVE A WRITING HEAD
RELATIVE TO AN AOM,
MULTI-LASER-BEAM SOURCE
AND A 1ST LENS ARRAY AND
RELATIVE TO A SUBSTRATE
HOLDER
— S10

OPERATE AOM
SYNCHRONIZED TO THE
MOVING
— S20

END

Fig. 9

Europäisches
Patentamt

European
Patent Office

Office européen
des brevets

# EUROPEAN SEARCH REPORT

Application Number

EP 23 15 0884

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 659 305 B1 (MICRONIC MYDATA AB [SE]) 4 January 2017 (2017-01-04) * paragraphs [0063], [0064]; figures 1a,1b,17,18 * | 1-11 | INV. G03F7/00 |
| A | EP 1 714 193 B1 (MYCRONIC AB [SE]) 1 August 2018 (2018-08-01) * paragraphs [0018], [0019], [0035] - [0043]; figures 1,4 * | 1-11 | |
| A | US 6 307 799 B1 (NGOI BRYAN KOK ANN [SG] ET AL) 23 October 2001 (2001-10-23) * columns 4-7; figures 1A-5C * | 1-11 | |
| A | US 2017/017163 A1 (KAJIYAMA KOICHI [JP] ET AL) 19 January 2017 (2017-01-19) * paragraphs [0007] - [0011], [0025] - [0031]; figures 1-2b, 6, 7 * | 1-11 | |
| A | US 2008/032066 A1 (STIBLERT LARS [SE] ET AL) 7 February 2008 (2008-02-07) * paragraphs [0157] - [0162]; figures 8-9C * | 1-11 | TECHNICAL FIELDS SEARCHED (IPC) G03F |
| A | US 2004/109164 A1 (HORII AKIHIRO [JP] ET AL) 10 June 2004 (2004-06-10) * paragraphs [0346] - [0357]; figures 27-29 * | 1-11 | |

The present search report has been drawn up for all claims

| Place of search | Date of completion of the search | Examiner |
|---|---|---|
| Munich | 7 June 2023 | Roesch, Guillaume |

EPO FORM 1503 03.82 (P04C01)

## ANNEX TO THE EUROPEAN SEARCH REPORT
## ON EUROPEAN PATENT APPLICATION NO.

EP 23 15 0884

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2023

| Patent document cited in search report | | Publication date | Patent family member(s) | | Publication date |
|---|---|---|---|---|---|
| EP 2659305 | B1 | 04-01-2017 | CN | 103299234 A | 11-09-2013 |
| | | | EP | 2659305 A1 | 06-11-2013 |
| | | | WO | 2012059581 A1 | 10-05-2012 |
| | | | WO | 2012059582 A1 | 10-05-2012 |
| EP 1714193 | B1 | 01-08-2018 | CN | 1918517 A | 21-02-2007 |
| | | | EP | 1714193 A1 | 25-10-2006 |
| | | | EP | 3480660 A1 | 08-05-2019 |
| | | | JP | 4389937 B2 | 24-12-2009 |
| | | | JP | 2007522523 A | 09-08-2007 |
| | | | KR | 20060107851 A | 16-10-2006 |
| | | | US | 2005181312 A1 | 18-08-2005 |
| | | | US | 2009170016 A1 | 02-07-2009 |
| | | | WO | 2005078527 A1 | 25-08-2005 |
| US 6307799 | B1 | 23-10-2001 | NONE | | |
| US 2017017163 | A1 | 19-01-2017 | CN | 105980933 A | 28-09-2016 |
| | | | JP | 6308523 B2 | 11-04-2018 |
| | | | JP | 2015173164 A | 01-10-2015 |
| | | | KR | 20160132376 A | 18-11-2016 |
| | | | TW | 201539150 A | 16-10-2015 |
| | | | US | 2017017163 A1 | 19-01-2017 |
| | | | WO | 2015137125 A1 | 17-09-2015 |
| US 2008032066 | A1 | 07-02-2008 | NONE | | |
| US 2004109164 | A1 | 10-06-2004 | US | 6687010 B1 | 03-02-2004 |
| | | | US | 2004109164 A1 | 10-06-2004 |

EPO FORM P0459

For more details about this annex : see Official Journal of the European Patent Office, No. 12/82